(19) Europäisches Patentamt

European Patent Office

Office européen des brevets

(11) **EP 1 208 386 B1**

(12) **EUROPEAN PATENT SPECIFICATION**

(45) Date of publication and mention
of the grant of the patent:
**29.01.2003 Bulletin 2003/05**

(21) Application number: **00942294.0**

(22) Date of filing: **07.07.2000**

(51) Int Cl.$^7$: **G01R 15/18**

(86) International application number:
**PCT/GB00/02604**

(87) International publication number:
**WO 01/014894 (01.03.2001 Gazette 2001/09)**

(54) **SENSOR FOR CURRENT MEASUREMENT AND ELECTRICITY METER**

SENSOR ZUM MESSEN VON STRÖMEN UND STROMZÄHLER

CAPTEUR POUR MESURE DE COURANT ET COMPTEUR ELECTRIQUE

(84) Designated Contracting States:
**DE FR GB NL**

(30) Priority: **24.08.1999 GB 9919891**

(43) Date of publication of application:
**29.05.2002 Bulletin 2002/22**

(73) Proprietor: **Siemens Metering Products Limited
Telford, Shropshire TF1 4ET (GB)**

(72) Inventor: **DYTCH, Anthony
Wolverhampton, Shropshire WV6 8EH (GB)**

(74) Representative: **Humphrey-Evans, Edward John
c/o Siemens AG
P.O. Box 22 16 34
80506 München (DE)**

(56) References cited:
**EP-A- 0 492 261          EP-A- 0 710 844
EP-A- 0 893 696          WO-A-87/01812
DE-A- 3 626 328          US-A- 5 041 780
US-A- 5 453 681**

## Description

The present invention relates to improvements in or relating to current measurement.

In electricity meters, there are several well known techniques for measuring the current. However, in some techniques, unwanted induced voltages in connections to the metering element produce undesired effects.

EP-A-0710844 teaches of a multi-coil gradiometric meter arrangement. WO 8701812 teaches of a current transformer for a static electricity counter.

It is therefore an object of the present invention to provide improved current measurement which does not suffer from the problems described above.

It is another object of the present invention to provide apparatus for measuring alternating or rectified alternating (discontinuous) electrical currents.

It is a further object of the invention to provide improve apparatus which reduces the cost and simplifies the method of measurement of current in an electricity meter.

In accordance with one aspect of the present invention, there is provided a current sensing arrangement comprising:-

a substantially flat current carrying conductor;
a printed circuit board placed contiguous with and lying in a plane parallel to the conductor; and
a printed circuit track formed on the printed circuit board and located on a surface thereof remote from the conductor, the printed circuit track comprising a sensor having two sensing loops arranged symmetrically about the conductor, the sensing loops being arranged symmetrically about the conductor, the sensing loops being arranged in a 'figure-of-eight' configuration.

The sensing loops can be of equal dimensions.

In accordance with another aspect of the present invention, there is provided an electricity meter including a current sensing arrangement as described above.

The electricity meter may be a single phase meter or a three-phase meter.

Advantageously, the printed circuit track is formed on a printed circuit board carrying processing circuitry for the electricity meter.

For a better understanding of the present invention, reference will now be made, by way of example only, to the accompanying drawing, the single Figure of which illustrates a current sensing arrangement in . accordance with the present invention.

A current carrying conductor in free space has a magnetic field around the conductor which is centred on the conductor. At any fixed point in space the magnitude of the magnetic field is directly proportional to the magnitude of the current flowing in the conductor. If a second conductor is placed alongside the current carrying conductor, the magnetic flux from the current carrying conductor loop will link to the second conductor loop. If the current in the current carrying conductor, and thus its magnetic field, is time varying, a voltage is induced in the second conductor loop proportional to the rate of change of the magnetic flux and thus the alternating part of the current in the first conductor. This is a basic law of electromagnetic induction. This principle is used as a measure of the current flow in a conductor.

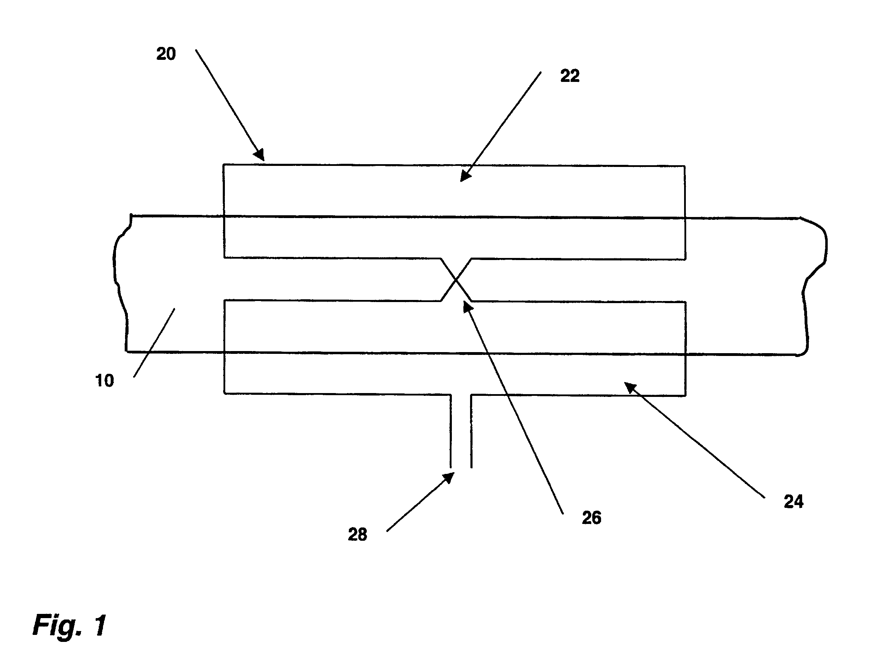

In Figure 1, a portion of a current carrying bus bar 10 is shown. A sensor 20 is arranged to overlie the bus bar 10, the sensor 20 comprising a sensing loop in the shape of a 'figure-of-eight' which provides two sensing loops 22, 24 having a central cross-over region 26. Each sensing loop 22, 24 comprises a rectangular sensing loop of equal dimensions which are connected in series in the 'figure-of-eight' configuration. Each sensing loop 22, 24 is approximately 50mm long (extending in the direction parallel to the bus bar 10) and approximately 30mm wide (from the cross-over region 26 to the outer edge). The sensor 20 is formed on a PCB (not shown) and is connected to an amplifier (not shown) by means of output 28.

The 'figure-of-eight' configuration reduces the effect of any externally induced interference. By placing the sensing loops 22, 24 in a symmetrical arrangement astride the bus bar 10, there are also has benefits in terms of sensing the current flow. The sensing loops 22, 24 are in opposition for uniform magnetic fields but they are in addition for the magnetic field round the bus bar 10. The sense of the sensor 20 is opposite on opposite edges of the bus bar 10, as is the direction of the magnetic field. Thus, the output of the sensing loops 22, 24 is nearly doubled compared with the situation where only one loop is employed.

The output 28 may be connected to an amplifier (not shown) which operates as a current to voltage signal conditioning stage. Alternatively, the output may be connected to a high impedance voltage amplifier (also not shown). The current to voltage signal conditioning stage allows control of the high frequency sensitivity of the sensing loops 22, 24. Equipping the high impedance voltage amplifier with an appropriately selected first order filter characteristic may be used to deal with the increasing sensor loop output with rise in frequency.

Additionally, at high frequencies, the self inductance of the sensing loops 22, 24 will play a part. Such self inductance appears as an inductance in series with the connection from the sensing loops 22, 24 to the current to voltage amplifier input. The presence of this inductance causes the current from the sensing loops 22, 24 into the amplifier to become constant with frequency as the impedance of the series inductance rises with frequency at the same rate as the induced voltage.

A number of effects can contribute to the variation of output/current sensing performance over temperature. The ones which are currently recognised are as follows:

1. Variations in the geometry of the current carrying bus bar and the printed circuit board, i.e. length, spacing, etc, due to thermal expansion
2. In the short circuit sense loop arrangement (with the current to voltage converter amplifier) the temperature coefficient of resistance of the copper printed circuit track.

It is anticipated that both the above temperature effects will appear as temperature dependent variations in the gain (scale factor) of the output and, as such, may be readily compensated by temperature sensors in close contact with the PCB track. It is not necessary for the temperature sensor to be in contact with the bus bar 10, hence simple voltage isolation can be maintained.

As noted above, the magnetic field at any point round the current carrying bus bar 10 is proportional to the current flowing in the bus bar. The output voltage of the PCB track (secondary) is proportional to the rate of change of flux linking it. This results in a 90° lagging phase shift between the primary current of the bus bar 10 and the voltage induced in the secondary. This occurs because of the ability of the primary circuit, in this case, the current in the bus bar 10, totally to dictate the magnetic conditions around the bus bar 10. The back emf generated by the inductance of the bus bar primary from the magnetic field produced by the current flowing in it does not impede the flow of current in the bar in any significant way. Neither does the secondary circuit have significant inductive reactance in order to introduce any phase difference at the supply frequency between the secondary voltage and current in it.

Thus, if the instantaneous primary current $i$ is

$$i = I_{max} \sin \omega t \qquad (1)$$

where

$I_{max}$ is the sinusoidal peak current in amps;
$\omega$ is the supply angular frequency in radians/sec; and
$t$ is the time in seconds

The instantaneous flux $\phi$ linking the PCB track secondary loop area from the instantaneous current $i$ is

$$\phi = \Phi_{max} \sin \omega t \qquad (2)$$

where $\Phi_{max}$ is the peak total magnetic flux from the bus bar primary linking the secondary loop in Webers

Then rate of change of change of the flux linking the secondary loop area is

$$\frac{d\phi}{dt} = \Phi_{max} \omega \cos \omega t \qquad (3)$$

Thus the voltage $e$ induced in the secondary loop is

$$e = n\Phi_{max}\omega \cos \omega t \qquad (4)$$

where $n$ is the number of turns on the secondary loop ($n = 2$ in this case)

Therefore, the voltage induced in the secondary loop is sinusoidal but phase shifted by 90° with respect to the primary current.

The appearance of the term $\omega$ before the cosine in equation (4) indicates that the induced voltage e is proportional to frequency and thus the sensor output will rise at 6dB per octave according to the frequency of the primary current.

Operated into a short circuit, such as the current to voltage converter would appear, the current will depend on the open circuit voltage as defined above and also on the total resistance of the secondary loops. It is anticipated that the magnetic coupling will be sufficiently loose such that the current in the secondary loop has little effect on the magnetic field linking it from the bus bar primary.

Thus, to a first approximation, the output of the current to voltage converter will be

$$E = -k\frac{n\Phi_{max}\omega\cos \omega t}{r} \qquad (5)$$

where

$E$ is the output voltage of the current to voltage converter in volts;
k is the current to voltage conversion ratio of the converter (volt/amp) and the negative sign indicates the phase inversion of such a converter; and
r is the total resistance of the loops in ohms

The above explanation avoids one critical aspect, namely, that of the total flux linkages. Basic magnetic theory only defines analytically the magnetic field from conductors of infinitely small cross section and of infinite length. The field at a point on a plane normal to a current carrying wire is defined as

$$B = \mu_0\frac{1}{2\pi r} \qquad (6)$$

where

$B$ is the magnetic flux density in Tesla;
$\mu_0$ is the permeability of free space in Henrys/metre;

*I* is the current in the conductor in amps; and

*r* is the radius from the conductor in metres

Thus the magnitude of the field is inversely proportional to the radius from the conductor. However, the current in the case of the bus bar primary will be substantially uniformly distributed across its cross sectional area. This spatially distributed current produces a spatially distributed magnetic field. A full treatment of the magnetic field produced by a current distributed in space is complex and is currently beyond the scope of this specification.

However, an 'order of magnitude' calculation may be performed as described below.

In order to calculate the voltage induced in a loop of known area one must know the total flux linking the loop. To obtain an estimate for the practical case, one may assume that the bus bar is of infinitely small cross section.

Following the above approach one may calculate the integral of the curve for the decay of field with distance from the bus bar, between the two distances equivalent to the dimensions of the parallel parts of the sense loop radially from the bus bar. This gives the value of the area under the field versus distance decay curve in Tesla metres. Multiplying by the dimension of the sense loop parallel to the bar gives a result in Tesla meter$^2$, or Webers (Wb), the total flux. This value is used in equation (2) above. The fact that two loops sense this flux equally doubles the total flux and the resulting voltage.

For a bus bar approximately 15mm wide and approximately 2mm thick, the calculation shows a flux of approximately 2μWb per loop making a total flux of approximately 4μWb. This, of course, is the rms value and should be multiplied by √2 to obtain the peak value for use in equation (2) above.

Using the rms value of flux and the supply angular frequency, one can calculate the approximate net rms voltage induced in the loop

$E = 4.10^{-6}\omega = 1.25mV$ for a 50Hz supply frequency.

The output voltage of the secondary conductor loop follows the same rules when the primary bus bar primary current is non-sinusoidal. A situation which must be considered here is one where the primary current consists only of a half wave of the supply waveform (half wave rectification).

In the above situation, where the inductances of the loops are not significant, the output voltage of the secondary is still proportional to the rate of change of flux which, in turn, is proportional to the rate of change of primary current. Thus, for the half wave rectified condition, the secondary output voltage is that of a gated cosine wave. Here, the output voltage follows the rate of change of the sine wave while it is present, but exhibits an instantaneous transition to or from zero as the half wave rectified current meets or leaves the zero current line.

As mentioned previously, the output from the secondary is directly proportional to the supply frequency as well as the magnitude of the primary current. Thus the output will require correction for supply frequency deviations from the calibration frequency. The sensitivity to frequency also applies to the harmonics of the primary current.

For a sinusoidal primary current the sensed voltage is directly proportional to the magnitude of the primary current. However, following from the above the output signal from the secondary in the case of a non-sinusoidal primary current requires particular treatment if the true root mean square current is to be ascertained. The 'rate of change' coupling produces a situation where the harmonic content of the signal rises at 6dB per octave. The processing of the signal therefore needs to take this into account.

The most obvious approach to signal processing is to convert the signal to digital format and to apply a Fourier transform to the signal to transfer it to the frequency domain. There a filter may be applied to the harmonics following which the true root mean square value of the fundamental and the harmonics may be computed.

The above task may be undemanding for many digital signal processing circuits currently on the market, most of which are aimed at high speed 'real time' processing of large amounts of data. Extreme speed is probably not necessary in this situation and thus it is possible that the processing may be carried out by the microprocessor which is almost certainly already part of the design.

The method of the present invention has the following advantages:

- simplicity
- possible implementation on the electronics PCB
- low cost
- inherent isolation from the supply voltage
- easy adaptation to a three-phase system

**Claims**

1. A current sensing arrangement (20) comprising:-

   a substantially flat current carrying conductor (10);
   a printed circuit board placed contiguous with and lying in a plane parallel to the conductor; and
   a printed circuit track formed on the printed circuit board and located on a surface thereof remote from the conductor, the printed circuit track comprising a sensor having two sensing loops (20, 24) arranged symmetrically about the conductor, the sensing loops being arranged in a 'figure-of-eight' configuration.

2. An arrangement according to claim 1, wherein the sensing loops are of equal dimensions.

3. An arrangement according to claim 1 or 2, wherein the sensing loops are substantially rectangular.

4. An electricity meter including a current sensing arrangement according to any one of the preceding claims.

5. A meter according to claim 4, comprising a single phase meter.

6. A meter according to claim 4, comprising a three-phase meter.

7. A meter according to any one of claims 4 to 6, wherein the printed circuit track is formed on a printed circuit board carrying processing circuitry for the electricity meter.

**Patentansprüche**

1. Strommeßanordnung (20), welche aufweist:

   einen im wesentlichen flachen stromführenden Leiter (10),

   eine gedruckte Leiterplatte, die angrenzend an den Leiter angeordnet ist und in einer zum Leiter parallelen Ebene liegt, und

   eine gedruckte Leiterbahn, die auf der gedruckten Leiterplatte ausgebildet ist und sich auf einer vom Leiter fernen Fläche davon befindet, wobei die gedruckte Leiterbahn einen Sensor mit zwei Meßschleifen (20, 24) aufweist, die symmetrisch um den Leiter angeordnet sind, wobei die Meßschleifen in einer "Achterkonfiguration" angeordnet sind.

2. Anordnung nach Anspruch 1, wobei die Meßschleifen gleiche Abmessungen haben.

3. Anordnung nach Anspruch 1 oder 2, wobei die Meßschleifen im wesentlichen rechteckig sind.

4. Strommeßgerät mit einer Strommeßanordnung nach einem der vorhergehenden Ansprüche.

5. Meßgerät nach Anspruch 4, welches ein Einphasen-Meßgerät einschließt.

6. Meßgerät nach Anspruch 4, welches ein Dreiphasen-Meßgerät einschließt.

7. Meßgerät nach einem der Ansprüche 4 bis 6, wobei die gedruckte Leiterbahn auf einer gedruckten Leiterplatte ausgebildet ist, die eine Verarbeitungsschaltungsanordnung für das Strommeßgerät aufweist.

**Revendications**

1. Dispositif de détection du courant (20) comprenant :

   un conducteur de transport de courant substantiellement plat (10) ;
   une carte de circuit imprimé placée de manière contiguë à et posée dans un plan parallèle au conducteur ; et
   une piste de circuits imprimés formée sur la carte de circuit imprimé et située sur une surface de celle-ci, à distance du conducteur, la piste de circuits imprimés comprenant un capteur ayant deux boucles de détection (20, 24) disposées symétriquement autour du conducteur, les boucles de détection étant disposées dans une configuration "en forme de huit".

2. Dispositif selon la revendication 1, dans lequel les boucles de détection sont de dimensions égales.

3. Dispositif selon la revendication 1 ou 2, dans lequel les boucles de détection sont substantiellement rectangulaires.

4. Compteur d'électricité comprenant un dispositif de détection du courant selon l'une quelconque des revendications précédentes.

5. Compteur selon la revendication 4, comprenant un compteur monophasé.

6. Compteur selon la revendication 4, comprenant un compteur triphasé.

7. Compteur selon l'une quelconque des revendications 4 à 6, dans lequel la piste de circuits imprimés est formée sur une carte de circuit imprimé portant les circuits de traitement du compteur d'électricité.

**Fig. 1**

EP 1 208 386 B1